# EUROPEAN PATENT APPLICATION

(11) **EP 4 465 459 A1**
(43) Date of publication of application: **20.11.2024**
(21) Application number: 24173548.9
(22) Date of filing: 30.04.2024
(51) Int. Cl.: H01S 5/14, H01S 3/107, H01S 3/083

(54) **OPTICAL MODULATION CHIP AND TUNABLE LASER**

(30) Priority: 06.05.2023 CN 202310504506
(71) Applicant: Suzhou Lycore Technologies Co., Ltd., Suzhou, Jiangsu 215123 (CN)
(72) Inventor: LIANG, Hanxiao, SUZHOU (CN); SONG, Yipin, SUZHOU (CN); ZHOU, Yingcong, SUZHOU (CN); WU, Haicang, SUZHOU (CN); MAO, Wenhao, SUZHOU (CN); SONG, Shiwei, SUZHOU (CN); SUN, Weiqi, SUZHOU (CN); YU, Qingyang, SUZHOU (CN); ZHANG, Zhouyu, SUZHOU (CN)
(74) Representative: Reddie & Grose LLP

(57) **Abstract**

An optical modulation chip and a tunable laser are provided. The optical modulation chip includes: an electro-optic phase modulation module configured to modulate a wavelength of laser light input thereto based on an electro-optic effect and a target wavelength mode; and a passband module receiving laser light output by the electro-optic phase modulation module, and configured to reflect and then output at least a portion of laser light of the target wavelength mode of laser light input thereto, and to dissipate laser light outside the target wavelength mode of the laser light input thereto.

## Description

### TECHNICAL FIELD

The present disclosure relates to the technical field of lasers, and in particular, to an optical modulation chip and a tunable laser.

### BACKGROUND ART

Tunable lasers refer to lasers that can continuously change a laser output wavelength within a certain range. Such lasers have a wide range of uses, and can be used in spectroscopy, photochemistry, medicine, biology, integrated optics, pollution monitoring, semiconductor material processing, information processing, communication, etc.

Implementation technology of the tunable lasers can be classified into current control technology, temperature control technology, mechanical control technology, etc. Tunable lasers based on the current control technology can realize wavelength tuning by changing an injection current, and have the characteristics of nanosecond (ns)-level tuning speed, relatively wide tuning bandwidth, but low output power. Such lasers mainly include sampled-grating distributed Bragg reflector (SG-DBR) lasers and grating assisted codirectional coupler with rear sampled grating reflector (GCSR) lasers. Tunable lasers based on the temperature control technology can change a laser output wavelength by changing the refractive index of an active region of the laser, and have the characteristics of simple technology, but slow speed and narrow tunable bandwidth (generally, only a few nanometers). Such lasers mainly include distributed feedback (DFB) lasers and distributed Bragg reflector (DBR) lasers. Tunable lasers based on the mechanical control technology are mainly based on micro-electromechanical system (MEMS) technology to realize wavelength selection, and have a relatively large tunable bandwidth and a relatively high output power. Such lasers mainly include distributed feedback (DFB) lasers, external-cavity lasers (ECL) and vertical-cavity surface-emitting lasers (VCSEL), etc.

For the tunable lasers based on the current control technology, how to enable the tunable laser to have an increased modulation speed and an improved operating performance is an urgent technical problem to be solved.

### SUMMARY OF THE INVENTION

The present disclosure provide an optical modulation chip and a tunable laser to enable the tunable laser to have an increased modulation speed and an improved operating performance.

According to an aspect of the present disclosure, provided is an optical modulation chip, including: an electro-optic phase modulation module configured to modulate a wavelength of laser light input based on an electro-optic effect and a target wavelength mode; and a passband module receiving laser light output by the electro-optic phase modulation module, and configured to reflect and then output at least a portion of laser light of the target wavelength mode of laser light input thereto, and to dissipate laser light outside the target wavelength mode of the laser light input thereto.

In some aspects, the passband module is configured as a fixed passband module with an operating passband that is incapable of being modulated; or the passband module is configured as an electro-optic passband modulation module with an operating passband that is capable of being modulated based on the electro-optic effect.

In some aspects, the passband module is configured as a passband grating module.

In some aspects, the passband module is configured as a distributed Bragg reflector passband grating module.

In some aspects, the optical modulation chip further includes: a gain medium configured to optically amplify laser light input thereto.

In some aspects, the optical modulation chip further includes: a reflection module configured to reflect laser light of the target wavelength mode of laser light directed thereto to a target module, and to reflect laser light outside the target wavelength mode of the laser light directed thereto to the outside of the target module, wherein the target module is the gain medium or the electro-optic phase modulation module.

In some aspects, the reflection module is configured as a fixed wavelength reflection module, which has an operating wavelength, at which the laser light is reflected to the target module, that is incapable of being modulated; or the reflection module is configured as an electro-optic reflection modulation module, which has an operating wavelength, at which the laser light is reflected to the target module, that is capable of being modulated based on the electro-optic effect.

In some aspects, the optical modulation chip includes the reflection module, the gain medium, the electro-optic phase modulation module and the passband module that are sequentially arranged; or the optical modulation chip includes the reflection module, the electro-optic phase modulation module, the gain medium and the passband module that are sequentially arranged.

In some aspects, the electro-optic phase modulation module includes: a strip waveguide and a waveguide electrode for applying an electric field to the strip waveguide; and/or a ring cavity waveguide and a waveguide electrode for applying an electric field to the ring cavity waveguide.

According to an aspect of the present disclosure, provided is a tunable laser, including an optical modulation chip in the previous aspect.

According to one or more aspects of the present disclosure, the optical modulation chip modulates the wavelength of the input laser light based on the electro-optic phase modulation module, which can enable the tunable laser to have a higher modulation speed, thereby significantly improving the operating performance of the tunable laser.

It should be understood that the content described in this section is not intended to identify critical or important features of the aspects of the present disclosure, and is not used to limit the scope of the present disclosure. Other features of the present disclosure will be easily understood through the following description.

### BRIEF DESCRIPTION OF THE DRAWINGS

More details, features, and advantages of the present disclosure are disclosed in the following description of example aspects with reference to the accompanying drawings, in which:
FIG. 1 is a schematic diagram of a simplified structure of an optical modulation chip according to some example aspects of the present disclosure;
FIG. 2 is a schematic diagram of a simplified structure of an optical modulation chip according to some example aspects of the present disclosure;
FIG. 3 is a schematic diagram of a simplified structure of an optical modulation chip according to some example aspects of the present disclosure;
FIG. 4 is a schematic diagram of a simplified structure of an optical modulation chip according to some example aspects of the present disclosure; and
FIG. 5 is a schematic diagram of a simplified structure of an optical modulation chip according to some example aspects of the present disclosure.

### Reference signs:

100. Optical modulation chip
110. Electro-optic phase modulation module
120. Passband module
130. Gain medium
140. Reflection module
11. Strip waveguide
12. Ring cavity waveguide
13. Waveguide electrode
21. Passband electrode
41. Total reflection mirror
42. Optical power distribution element
43. Open port
44. Directional coupler

### DETAILED DESCRIPTION OF EMBODIMENTS

Only some example aspects are briefly described below. As can be appreciated by those skilled in the art, the described aspects can be modified in various ways without departing from the spirit or scope of the present disclosure. Accordingly, the accompanying drawings and the description are considered as illustrative in nature, and not as restrictive.

Most tunable lasers are required to output laser light of a single wavelength mode, however, a laser having a fixed cavity length may have a plurality of wavelength modes. When the cavity length of the laser is equal to an integer multiple of an effective wavelength, the mode can be kept stable for a wavelength that is an integral multiple of the effective wavelength. Usually, when designing a structure of the tunable laser, the structure of the tunable laser is generally designed based on laser light of a target wavelength mode, and is designed to have the minimum loss, and then, the laser light of the target wavelength mode is optically amplified and laser light of other wavelength modes is filtered out, so as to achieve the purpose of outputting the laser light of the single wavelength mode.

In the related art, tuning of laser light by the tunable laser is mostly realized by modulating passband of a reflection region and of a transmission region based on a thermo-optic effect, and the modulation speed is not ideal.

Aspects of the present disclosure provide an optical modulation chip and a tunable laser to enable the tunable laser to have an increased modulation speed and an improved operating performance.

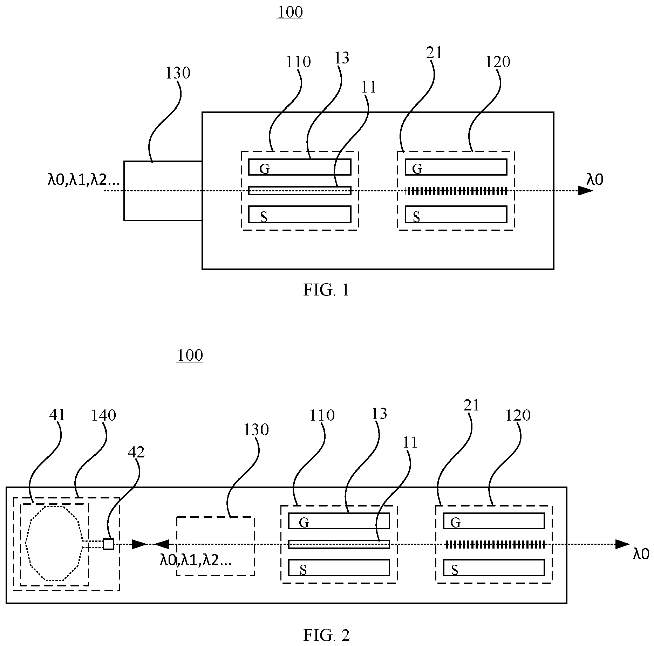

As shown in FIG. 1, in some aspects of the present disclosure, an optical modulation chip 100 includes an electro-optic phase modulation module 110 and a passband module 120, wherein the electro-optic phase modulation module 110 is configured to modulate a wavelength of laser light input thereto based on an electro-optic effect and a target wavelength mode (such as λ0), and the passband module 120 receives laser light output by the electro-optic phase modulation module 110, and is configured to reflect and then output at least a portion of laser light of the target wavelength mode of laser light input thereto, and to dissipate laser light outside the target wavelength mode of the laser light input thereto.

For example, as shown in FIG. 1, wavelengths of laser light input to the optical modulation chip 100 through a gain medium 130 may include various modes, such as λ0, λ1, and λ2, the target wavelength mode is λ0, and assuming that a reflection ratio of the passband module 120 is r (r being less than 1), the passband module 120 would continuously reflect light having a wavelength mode of λ0 at the reflection ratio of r, so that light enters the gain medium 130 for amplification, in which a small portion of the light having the wavelength mode of X0 is output, and light having wavelength modes of λ 1 and λ 2 is dissipated by the passband module 120.

The electro-optic phase modulation module 110 is made based on the electro-optic effect of an electro-optic material. The electro-optic effect means that when a voltage is applied to an electro-optic material such as a lithium niobate crystal, a gallium arsenide crystal, or a lithium tantalate crystal, a refractive index of the electro-optic material will vary, resulting in a change in characteristics of light waves passing through the electro-optic material. The use of the electro-optic effect allows modulation of parameters, such as the phase, amplitude, intensity and polarization state, of optical signals.

Compared with the related art, the optical modulation chip 100 according to the aspects of the present disclosure modulates the wavelength of the input laser light based on the electro-optic phase modulation module 110, which can enable the tunable laser to have a higher modulation speed, thereby significantly improving the operating performance of the tunable laser.

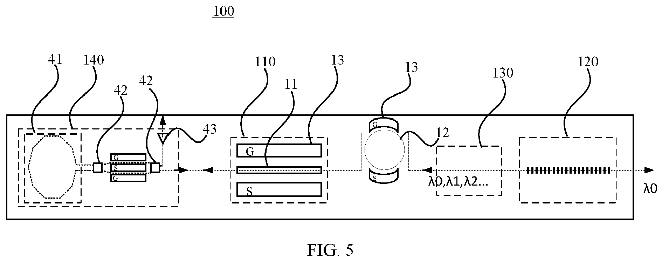

In some aspects of the present disclosure, the electro-optic phase modulation module 110 includes: a strip waveguide 11 and a waveguide electrode 13 for applying an electric field to the strip waveguide 11. In addition, the electro-optic phase modulation module 110 may further include a ring cavity waveguide 12 and a waveguide electrode 13 for applying an electric field to the ring cavity waveguide 12 (see FIG. 5).

The strip waveguide 11 has a simple structure, and for example, a strip ridge waveguide may be used. The ring cavity is a traveling wave resonant cavity, and laser light propagates in the resonant cavity in a traveling wave mode, so that a spatial hole burning effect common in a linear cavity can be overcome, and the output power is high. The ring cavity is designed to be of a specific wavelength mode, and only laser light of the specific wavelength mode can be output through the ring cavity, and by applying an electric field to the waveguide of the electro-optic material by means of the waveguide electrode 13, a corresponding wavelength mode can be obtained by means of modulation.

In the aspects of the present disclosure, the passband module 120 may be configured as a fixed passband module with an operating passband that cannot be modulated, or as an electro-optic passband modulation module with an operating passband that can be modulated based on the electro-optic effect. When the passband module 120 is the electro-optic passband modulation module, the electro-optic passband modulation module is made based on the electro-optic effect of the electro-optic material, and the operating passband thereof can be adjusted under the control of a passband electrode 21.

In the aspects of the present disclosure, the passband module 120 may be configured as a passband grating module, and for example, may be a distributed Bragg reflector DBR passband grating module. The DBR is of a periodic structure composed of two alternately arranged materials having different refractive indexes, and each layer of material has an optical thickness of 1/4 of a central reflection wavelength. Since electromagnetic waves having frequencies within an energy gap cannot be transmitted, the reflectivity of the DBR can reach 99% and more. Moreover, there is no absorption problem in a metal mirror, and a position of the energy gap can be adjusted by changing the refractive index or thickness of the material.

In some aspects of the present disclosure, as shown in FIG. 1, the gain medium 130 may not be included in the optical modulation chip 100, and an input end of the optical modulation chip 100 is optically coupled to the gain medium 130. The gain medium 130 is configured to optically amplify laser light input thereto. In laser physics, the gain medium refers to a medium that can amplify optical power (generally, in the form of a beam).

As shown in FIG. 2, in some aspects, the gain medium 130 may also be included in the structure of the optical modulation chip 100, that is, the gain medium 130 is integrated in the structure of the optical modulation chip 100.

As shown in FIG. 2, in some aspects of the present disclosure, the optical modulation chip 100 further includes a reflection module 140, which is configured to reflect laser light of the target wavelength mode of laser light directed thereto to a target module, and to reflect laser light outside the target wavelength mode of the laser light directed thereto to the outside of the target module, wherein the target module is the gain medium 130 or the electro-optic phase modulation module 110.

The reflection module 140 can be used to reflect and screen the laser light directed thereto, so that the laser light corresponding to an operating wavelength (i.e., the target wavelength mode) of the reflection module can be reflected to the target module, and the laser light not corresponding to the operating wavelength (i.e., outside the target wavelength mode) of the reflection module can be reflected and leaked out. In some aspects, the reflection module 140 includes a total reflection mirror 41.

As shown in FIG. 2, in some aspects, the reflection module 140 is configured as a fixed wavelength reflection module, which has an operating wavelength. at which the laser light is reflected to the target module, that cannot be modulated.

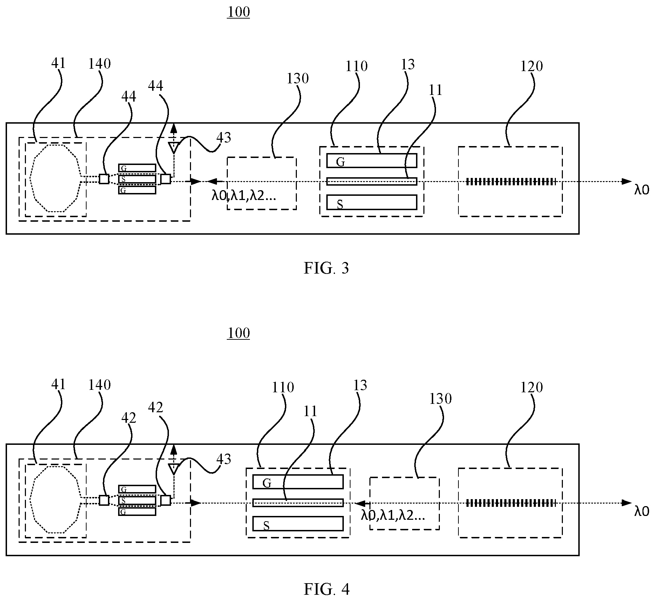

As shown in FIG. 3, in some other aspects of the present disclosure, the reflection module 140 is configured as an electro-optic reflection modulation module, which is made based on the electro-optic effect of the electro-optic material, and has an operating wavelength, at which the laser light is reflected to the target module, that can be modulated based on the electro-optic effect.

As shown in FIG. 1, in some aspects, the optical modulation chip 100 includes the electro-optic phase modulation module 110 and the passband module 120, wherein the passband module 120 is the electro-optic passband modulation module. The electro-optic phase modulation module 110 is designed with the strip waveguide 11.

As shown in FIG. 2, in some aspects, the optical modulation chip 100 includes the reflection module 140, the gain medium 130, the electro-optic phase modulation module 110 and the passband module 120 that are sequentially arranged, wherein the reflection module 140 is the fixed wavelength reflection module, and the passband module 120 is the electro-optic passband modulation module. The electro-optic phase modulation module 110 is designed with the strip waveguide 11. In this aspect, the reflection module 140 includes the total reflection mirror 41 and an optical power distribution element 42 configured to enable input laser light to be split into two and then to enter the total reflection mirror 41.

As shown in FIG. 3, in some aspects, the optical modulation chip 100 includes the reflection module 140, the gain medium 130, the electro-optic phase modulation module 110 and the passband module 120 that are sequentially arranged, wherein the reflection module 140 is the electro-optic reflection modulation module, and the passband module 120 is the fixed passband module. The electro-optic phase modulation module 110 is designed with the strip waveguide 11.

As shown in FIG. 4, in some aspects, the optical modulation chip 100 includes the reflection module 140, the electro-optic phase modulation module 110, the gain medium 130 and the passband module 120 that are sequentially arranged, wherein the reflection module 140 is the electro-optic reflection modulation module, and the passband module 120 is the fixed passband module. The electro-optic phase modulation module 110 includes the strip waveguide 11.

As shown in FIG. 5, in some aspects, the optical modulation chip 100 includes the reflection module 140, the electro-optic phase modulation module 110, the gain medium 130 and the passband module 120 that are sequentially arranged, wherein the reflection module 140 is the electro-optic reflection modulation module, and the passband module 120 is the fixed passband module. The electro-optic phase modulation module 110 includes the strip waveguide 11 and the ring cavity waveguide 12.

In the aspect shown in FIG. 5, the electro-optic reflection modulation module may include two directional couplers 44, so that laser light of the target wavelength mode is emitted to the electro-optic phase modulation module 110, and laser light of other wavelength modes leak out from an open port 43. The directional coupler is a microwave device widely used in a microwave system, and essentially performs a power distribution on microwave signals according to a certain proportion.

It should be noted that the structure of the optical modulation chip in the present disclosure is not limited to the structures of the above aspects. In some aspects of the present disclosure, for example, the optical modulation chip may also include a thermal phase modulation module, so that the tunable laser can have a wider range of modulation, and the electro-optic phase modulation module cooperates with the thermal phase modulation module, which can make the tunable laser additionally have a faster modulation speed.

An aspect of the present disclosure also provides a tunable laser, including an optical modulation chip 100 of any of the foregoing aspects. The tunable laser has a relatively high modulation speed and a better operating performance. The specific type of the tunable laser is not limited, and for example, the tunable laser may be a DFB laser or a DBR laser.

It should be understood that, in this description, the orientations or positional relationships or dimensions denoted by the terms, such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial" and "circumferential", are the orientations or positional relationships or dimensions shown based on the accompanying drawings, and these terms are used merely for ease of description, rather than indicating or implying that the device or element referred to must have particular orientations and be constructed and operated in the particular orientations, and therefore should not be construed as limiting the scope of protection of the present disclosure.

In addition, the terms such as "first", "second" and "third" are merely for descriptive purposes and should not be construed as indicating or implying relative importance or implicitly indicating the number of technical features indicated. Thus, the features defined with "first", "second" and "third" may explicitly or implicitly include one or more features. In the description of the present disclosure, the term "a plurality of" means two or more, unless otherwise explicitly and specifically defined.

In the present disclosure, unless expressly stated or defined otherwise, the terms such as "mounting", "connection", "connected" and "fixing" should be interpreted broadly, for example, they may be a fixed connection, a detachable connection, or an integrated connection; may be a mechanical connection, or an electrical connection, or communication; and may be a direct connection or an indirect connection by means of an intermediate medium, or may be internal communication between two elements or interaction between the two elements. For those of ordinary skill in the art, the specific meanings of the above terms in the present disclosure can be understood according to specific circumstances.

In the present disclosure, unless expressly stated or defined otherwise, the expression of the first feature being "above" or "below" the second feature may include the case that the first feature is in direct contact with the second feature, or the case that the first feature and the second feature are not in direct contact but are contacted via another feature therebetween. Furthermore, the first feature being "over", "above" or "on" the second feature includes the case that the first feature is directly or obliquely above the second feature, or merely indicates that the first feature is at a higher level than the second feature. The first feature being "below", "under" or "beneath" the second feature includes the case that the first feature is directly or obliquely below the second feature, or merely indicates that the first feature is at a lower level than the second feature.

This description provides many different implementations or examples that can be used to implement the present disclosure. It should be understood that these different implementations or examples are purely illustrative and are not intended to limit the scope of protection of the present disclosure in any way. Based on the disclosure of the description of the present disclosure, those skilled in the art will be able to conceive of various changes or substitutions. All these changes or substitutions shall fall within the scope of protection of the present disclosure. Therefore, the scope of protection of the present disclosure shall be subject to the scope of protection of the claims.

## Claims

1. An optical modulation chip (100), comprising:
an electro-optic phase modulation module (110) configured to modulate a wavelength of laser light input thereto based on an electro-optic effect and a target wavelength mode; and
a passband module (120) receiving laser light output by the electro-optic phase modulation module (110), and configured to reflect and then output at least a portion of laser light of the target wavelength mode of laser light input thereto, and to dissipate laser light outside the target wavelength mode of the laser light input thereto.

2. The optical modulation chip (100) according to claim 1, wherein
the passband module (120) is configured as a fixed passband module with an operating passband that is incapable of being modulated; or
the passband module (120) is configured as an electro-optic passband modulation module with an operating passband that is capable of being modulated based on an electro-optic effect.

3. The optical modulation chip (100) according to claim 2, wherein
the passband module (120) is configured as a passband grating module.

4. The optical modulation chip (100) according to claim 3, wherein
the passband module (120) is configured as a distributed Bragg reflector passband grating module.

5. The optical modulation chip (100) according to claim 2, further comprising:
a gain medium (130) configured to optically amplify laser light input thereto.

6. The optical modulation chip (100) according to claim 5, further comprising:
a reflection module (140) configured to reflect laser light of the target wavelength mode of laser light directed thereto to a target module, and to reflect laser light outside the target wavelength mode of laser light directed thereto to the outside of the target module, wherein the target module is the gain medium (130) or the electro-optic phase modulation module (110).

7. The optical modulation chip (100) according to claim 6, wherein
the reflection module (140) is configured as a fixed wavelength reflection module, which has an operating wavelength, at which the laser light is reflected to the target module, that is incapable of being modulated; or
the reflection module (140) is configured as an electro-optic reflection modulation module, which has an operating wavelength, at which the laser light is reflected to the target module, that is capable of being modulated based on an electro-optic effect.

8. The optical modulation chip (100) according to claim 7, wherein
the optical modulation chip (100) comprises the reflection module (140), the gain medium (130), the electro-optic phase modulation module (110) and the passband module (120) that are sequentially arranged; or
the optical modulation chip (100) comprises the reflection module (140), the electro-optic phase modulation module (110), the gain medium (130) and the passband module (120) that are sequentially arranged.

9. The optical modulation chip (100) according to any one of claims 1 to 8, wherein the electro-optic phase modulation module (110) comprises:
a strip waveguide (11) and a waveguide electrode for applying an electric field to the strip waveguide (11); and/or
a ring cavity waveguide (12) and a waveguide electrode for applying an electric field to the ring cavity waveguide (12).

10. A tunable laser, comprising an optical modulation chip (100) according to any one of claims 1 to 9.
